# EUROPEAN PATENT APPLICATION

(11) **EP 4 216 666 A2**
(43) Date of publication of application: **26.07.2023**
(21) Application number: 23150314.5
(22) Date of filing: 04.01.2023
(51) Int. Cl.: H05B 3/00

(54) **LAMP FOR HEATING AND HEATING APPARATUS INCLUDING THE SAME**

(30) Priority: 19.01.2022 JP 2022006066; 31.01.2022 JP 2022013291
(71) Applicant: Phoenix Electric Co., Ltd., Himeji-shi, Hyogo 679-2122 (JP)
(72) Inventor: GOUDA, Tetsuya, Himeji-shi, 6792122 (JP); YAMASHITA, Kenichi, Himeji-shi, 6792122 (JP); KINOSHITA, Masaaki, Himeji-shi, 6792122 (JP)
(74) Representative: Horn Kleimann Waitzhofer Patentanwälte PartG mbB

(57) **Abstract**

It is intended to provide a lamp for heating, by which a wafer can be uniformly heated to a required temperature in a short time, and a heating apparatus including the same. A lamp (100) for heating is composed of a heat dissipation substrate (102) made of metal, an insulating layer (104) disposed on the heat dissipation substrate (102), a plurality of wiring patterns (106) disposed on the insulating layer (104), a plurality of light source elements (108) disposed on the plurality of wiring patterns (106) on a one-to-one basis, a joining material (109) electrically joining each of the plurality of wiring patterns (106) and each of the plurality of light source elements (108), and a metal wiring (110) electrically connecting each adjacent pair of the plurality of light source elements (108).

## Description

### BACKGROUND OF THE INVENTION

### FIELD OF THE INVENTION

The present invention relates to a lamp for heating a heated material, for instance, a wafer or so forth, and a heating apparatus including the same.

### BACKGROUND ART

Apparatuses for heating a wafer for manufacturing a semiconductor with LED (Light-Emitting Diode) lamps have been proposed so far (e.g., Japan Laid-open Patent Application Publication No. 2012-178576 (dome type) and Japanese Translation of PCT International Application Publication No. 2005-536045 (bullet type)).

Besides, chances are that "burn-in" treatment is performed in a manufacturing process for a semiconductor so as to screen an initial failure by applying a load to a completed semiconductor with a voltage or operating frequency of the maximum rated value or greater and further heating the completed semiconductor. It has been also proposed to use LED lamps for heating in the burn-in treatment herein described (e.g., Japan Laid-open Patent Application Publication No. 2002-208620).

On the other hand, the LED lamps are advantageous in quick response speed, superior dimming control, and so forth; hence, it is now being considered to use the LED lamps even in other heating processes in which halogen lamps has been conventionally used. The term "other heating processes" refers to, for instance, resist curing, oxidizing, preliminary heating in flash annealing, annealing under vacuum or pressure, or so forth.

### SUMMARY OF THE INVENTION

However, it costs too much to perform the burn-in treatment with respect to a semiconductor obtained as a completed product; hence, in recent years, there have appeared manufactures abolishing the step of burn-in treatment. On the other hand, there has also been proposed "wafer-level burn-in treatment" that the step of burn-in treatment, even though not abolished, is performed with respect to a semiconductor, while the semiconductor is still in a wafer state before obtained as a completed product. The burn-in treatment is normally performed with respect to a completed semiconductor for several to dozens of hours. By contrast, in some cases, the burn-in treatment can be completed with respect to a wafer-level semiconductor for only dozens of seconds, whereby the manufacturing cost of the semiconductor can be greatly reduced.

In attempt to perform the burn-in treatment with respect to a wafer, it is necessary to uniformly heat the wafer to a required temperature in a short time. When conventional LED lamps for heating are herein used, the wafer cannot be uniformly heated in a short time; namely, a drawback of large fluctuations in temperature of the wafer is inevitable.

The present invention has been produced in view of the drawback described above. It is an object of the present invention to provide a lamp for heating, by which a wafer can be uniformly heated to a required temperature in a short time, and a heating apparatus including the same.

According to an aspect of the present invention, a lamp for heating is provided. The lamp for heating includes a heat dissipation substrate made of metal, an insulating layer disposed on the heat dissipation substrate, a plurality of wiring patterns disposed on the insulating layer, a plurality of light source elements disposed on the plurality of wiring patterns on a one-to-one basis, a joining material electrically joining each of the plurality of wiring patterns and each of the plurality of light source elements, and a metal wiring electrically connecting each adjacent pair of the plurality of light source elements.

According to another aspect of the present invention, a lamp for heating is provided. The lamp for heating includes an insulating material made of ceramic, a plurality of wiring patterns disposed on the insulating material, a plurality of light source elements disposed on the plurality of wiring patterns on a one-to-one basis, a joining material electrically joining each of the plurality of wiring patterns and each of the plurality of light source elements, and a metal wiring electrically connecting each adjacent pair of the plurality of light source elements.

Preferably, a VCSEL (Vertical Cavity Surface Emitting Laser) element is used as the each of the plurality of light source elements.

According to yet another aspect of the present invention, a heating apparatus is provided. The heating apparatus includes a plurality of lamps, each of which is identical to the lamp configured as any of the above, a heat dissipation member, to which the each of the plurality of lamps is attached through a thermally conductive material, and an electric driver driving the plurality of light source elements.

Preferably, the plurality of light source elements disposed in the each of the plurality of lamps are divided into a plurality of groups. Besides, the electric driver separately drives the plurality of light source elements on a group basis.

Preferably, the electric driver controls the plurality of light source elements on the group basis with shifted timing.

Preferably, the plurality of lamps are attached to the heat dissipation member such that the each of the plurality of lamps produces a gap at part or entirety of a circumference thereof against one adjacent thereto of the plurality of lamps.

Preferably, at least either a temperature sensor or an infrared camera is disposed in the gap so as to measure a temperature of a wafer under heating.

Preferably, the electric driver regulates values of electric current to be supplied to the plurality of lamps based on the temperature of the wafer detected by the at least either the temperature sensor or the infrared camera.

Preferably, the electric driver increases values of electric current to be supplied to the plurality of light source elements depending on time-dependent deterioration of the plurality of light source elements.

Preferably, the electric driver uniquely regulates values of electric current to be supplied to the plurality of lamps on a lamp basis depending on time-dependent deterioration of the plurality of light source elements in the each of the plurality of lamps.

Preferably, the heating apparatus further includes an optical filter arranged and set between the plurality of lamps and the wafer. Besides, the optical filter blocks rays of light having a wavelength longer than a wavelength detected by the at least either the temperature sensor or the infrared camera. Advantageous Effects of Invention

In the lamp for heating according to the present invention, each of the plurality of light source elements is electrically joined to each of the plurality of wiring patterns through the joining material, whereby the plurality of light source elements can be prevented from becoming high in temperature; hence, the wafer can be uniformly heated to a required temperature in a short time.

### BRIEF DESCRIPTION OF THE DRAWINGS

Referring now to the attached drawings which form a part of this original disclosure:
FIG. 1 is a cross-sectional view of a lamp 100 according to an exemplary embodiment to which the present invention is applied;
FIG. 2 is a cross-sectional view of a heating apparatus 150 according to the exemplary embodiment to which the present invention is applied;
FIG. 3 is a plan view of the heating apparatus 150 according to the exemplary embodiment to which the present invention is applied;
FIG. 4 is a plan view of the heating apparatus 150 according to another example;
FIG. 5 is a plan view of the heating apparatus 150 according to yet another example;
FIG. 6 is a cross-sectional view of the lamp 100 according to modification 1;
FIG. 7 is a plan view of the heating apparatus 150 according to the modification 1; and
FIG. 8 is a view of the heating apparatus 150 according to modification 5.

### DETAILED DESCRIPTION OF EMBODIMENTS

### (Structure of Lamp 100 for Heating)

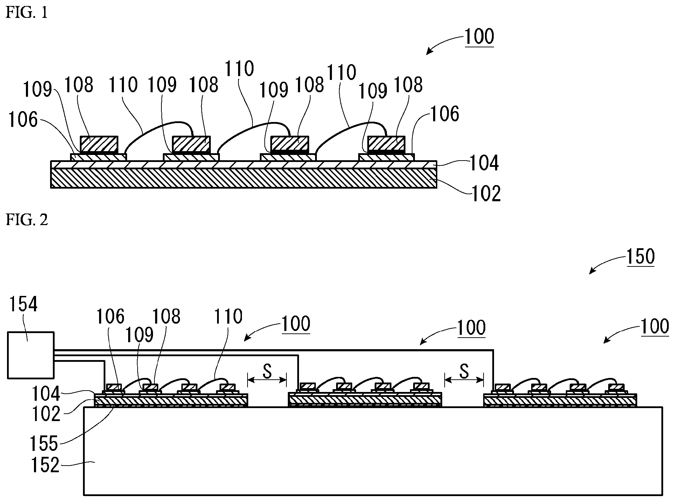

The lamp 100 for heating, to which the present invention is applied, will be explained with drawings. FIG. 1 is a view of the lamp 100 according to the present exemplary embodiment.

The lamp 100 according to the present exemplary embodiment is mainly composed of a heat dissipation substrate 102, an insulating layer 104, wiring patterns 106, VCSEL (Vertical Cavity Surface Emitting Laser) elements 108 provided as light source elements, joining materials 109, and metal wirings 110.

The heat dissipation substrate 102 is a plate member made of metal, and as described below, is configured to be attached to a heat dissipation member 152. In general, the heat dissipation substrate 102 is made of copper, aluminum, an alloy of copper or aluminum, or so forth. It should be noted that the metal, of which the heat dissipation substrate 102 is made, is not limited to a particular material; besides, it does not matter whether or not the material has electric conductivity. However, it is herein preferable to select a material with high thermal conductivity as the metal of which the heat dissipation substrate 102 is made.

The insulating layer 104 is disposed on the heat dissipation substrate 102 and can be made of a ceramic material (alumina, aluminum nitride, silicon carbide, etc.), diamond-like carbon, a resin with good thermal conductivity and high insulating properties, or so forth. Besides, the following layer forming method can be used to form the insulating layer 104: thermal spraying, CVD (Chemical Vapor Deposition), printing, or so forth. In any case, the insulating layer 104 is not limited to a particular configuration as long as occurrence of undesirable electric conductivity can be prevented therethrough between the wiring patterns 106 and the heat dissipation substrate 102.

The wiring patterns 106 serve to electrify the VCSEL elements 108 and are formed in equal number to the VCSEL elements 108 implemented on the surface of the insulating layer 104. Besides, each adjacent pair of the wiring patterns 106 is disposed away from each other so as to reliably achieve electric insulating properties therebetween.

Any of the following materials can be exemplified as the material of the wiring patterns 106: copper, tungsten, tantalum, molybdenum, niobium, nickel, palladium, gold, silver, and so forth.

The VCSEL elements 108, provided as the light source elements, are surface emitting semiconductor laser array elements disposed on the plural wiring patterns 106 on a one-to-one basis and are capable of emitting rays of light in a direction vertical to the substrate surface. It is preferable that the rays of light emitted from the VCSEL elements 108 have a wavelength of greater than or equal to 600 nm and less than or equal to 1200 nm. Here, it is preferable that the rays of light have a wavelength of greater than or equal to 600 nm because light absorption by a silicon wafer deteriorates in wavelength absorption characteristics when the rays of light have a wavelength of shorter than 600 nm. On the other hand, it is preferable that the rays of light have a wavelength of less than or equal to 1200 nm because light absorption by the silicon wafer peaks out at 1200 nm in the wavelength absorption characteristics and acutely deteriorates when the rays of light have a wavelength of longer than 1200 nm.

The joining materials 109 are materials for electrically joining the wiring patterns 106 and the VCSEL elements 108 and can be exemplified by die-attaching adhesive. Obviously, any suitable material other than the die-attaching adhesive may be used as the joining materials 109; besides, the joining materials 109 can be used in a solid form or a paste form.

The metal wirings 110 are members for electrically connecting the VCSEL elements 108 adjacent to each other. For example, a method such as wire bonding is used for the metal wirings 110.

### (Structure of Heating Apparatus 150)

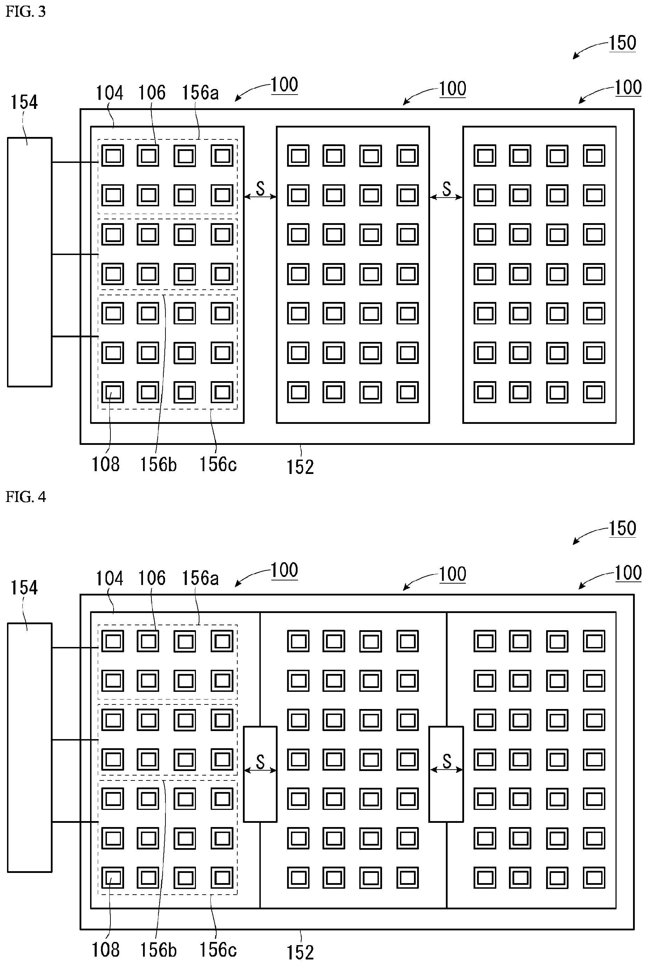

Next, the structure of the heating apparatus 150 including one or more lamps 100 for heating described above will be explained. The heating apparatus 150 is provided for hearting a heated material (e.g., a wafer, etc.) by burn-in treatment or any other suitable heating process. As shown in FIGS. 2 and 3, the heating apparatus 150 mainly includes a plurality of lamps 100, the heat dissipation member 152, and an electric driver 154. It should be noted that it is preferable to heat a work to 100 degrees Celsius or greater with the heating apparatus 150. For example, a wafer is heated to a temperature of slightly greater than 100 degrees Celsius in a processing step of drying but is heated to a temperature of 600 degrees Celsius or greater in a processing step of annealing or so forth.

The heat dissipation member 152 is a member to which the plural lamps 100 described above are attached. Specifically, in each lamp 100, the heat dissipation substrate 102 is attached to the surface of the heat dissipation member 152 through a thermally conductive material 155 (grease or sheet material with high thermal conductivity).

The heat dissipation member 152 is made of a material with high thermal conductivity (e.g., copper, aluminum, etc.) and is configured to be air-cooled or water-cooled so as to receive heat generated by the VCSEL elements 108 through the thermally conductive material 155.

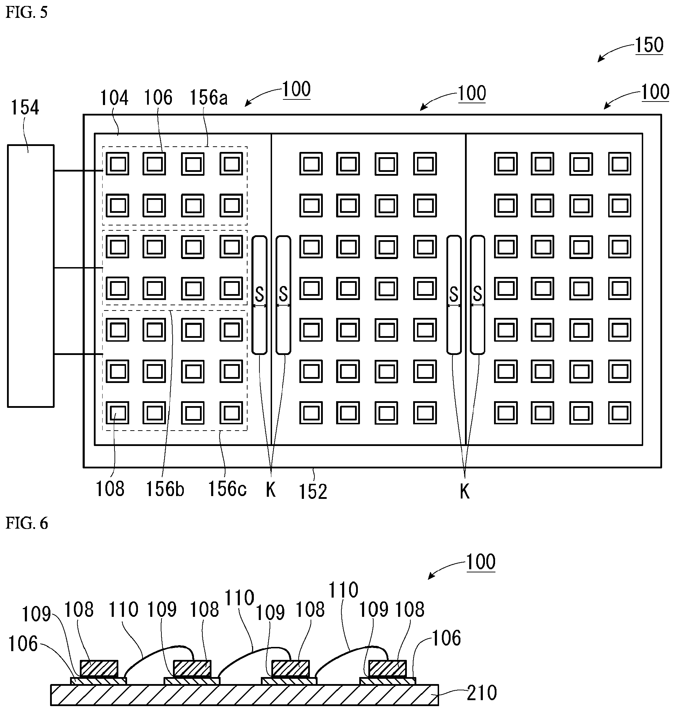

It should be noted that, when attached to the heat dissipation member 152, the plural lamps 100 are disposed such that each lamp 100 produces a gap S, at part or the entirety of the circumference thereof, against at least one lamp 100 adjacent thereto. It should be noted that, for instance, the gap S may be produced at "part of the circumference" in the following configuration: As shown in FIG. 4, the gap S is produced, while one of each adjacent pair of lamps 100 is disposed away from the other at part of the outer peripheral side thereof. Alternatively, the gap S is assumed to be produced at "part of the circumference" as well in the following configuration: As shown in FIG. 5, each lamp 100 is provided with at least one missing part K (exemplified as at least one elongated hole in the drawing) along the circumference thereof. Here, each adjacent pair of lamps 100 is abutted to each other at the circumferential edges thereof; however, the missing parts K exist between part of the VCSEL elements 108 in one of each adjacent pair of lamps 100 and part of the VCSEL elements 108 in the other.

The electric driver 154 is a member serving to supply electric power for light emission to the plural VCSEL elements 108 disposed in each lamp 100. In the heating apparatus 150 according to the present exemplary embodiment, the plural VCSEL elements 108 disposed in each lamp 100 are grouped into a plurality of groups (three groups 156a, 156b, and 156c in the present exemplary embodiment); besides, the electric driver 154 is configured to be capable of separately driving the VCSEL elements 108 belonging to the group 156a, those belonging to the group 156b, and those belonging to the group 156c on a group basis.

For example, it is preferable for the electric driver 154 to control the VCSEL elements 108 belonging to the group 156a, those belonging to the group 156b, and those belonging to the group 156c on a group basis with shifted timing. This is because, when the VCSEL elements 108 belonging to the plural groups 156a, 156b, and 156c are simultaneously turned on, increase in temperature cannot be made uniformly because of individual differences among electric supplies (electric drivers 154) and/or those among the VCSEL elements 108. Controlling the VCSEL elements 108 "with shifted timing" can be exemplified by turning on one group disposed closest to a large heat dissipating site (the vicinity of pins for supporting the wafer, etc.) before turning on the other groups among the groups 156a, 156b, and 156c.

It should be noted that only a single electric driver 154 may be set in a single heating apparatus 150; alternatively, a single or plurality of electric drivers 154 may be set in one-to-one correspondence to a single or plurality of lamps 100. Yet alternatively, two or more lamps 100, composing part of a plurality of lamps 100 disposed in a single heating apparatus 150, may be set in correspondence to a single electric driver 154.

(Characteristics of Lamp 100 for Heating and Heating Apparatus 150) In the lamp 100 for heating and the heating apparatus 150 according to the present exemplary embodiment, the VCSEL elements 108 are used as the heat sources (light sources) for heating. The rays of light emitted from the VCSEL elements 108 have a wavelength ranging on a relatively longer wavelength side than those emitted from LEDs; hence, the wafer can be efficiently increased in temperature.

### (Modification 1)

In the lamp 100 described above, the insulating layer 104 is formed on the heat dissipation substrate 102 made of metal; then, the wiring patterns 106 are disposed on the upper surface thereof. Alternatively, as shown in FIG. 6, the lamp 100 may be composed of an insulating material 210 made of ceramic, a plurality of wiring patterns 106 disposed on the insulating material 210, a plurality of VCSEL elements 108 disposed on the plural wiring patterns 106 on a one-to-one basis, and a plurality of metal wirings 110 each electrically connecting each adjacent pair of the plural VCSEL elements 108.

### (Modification 2)

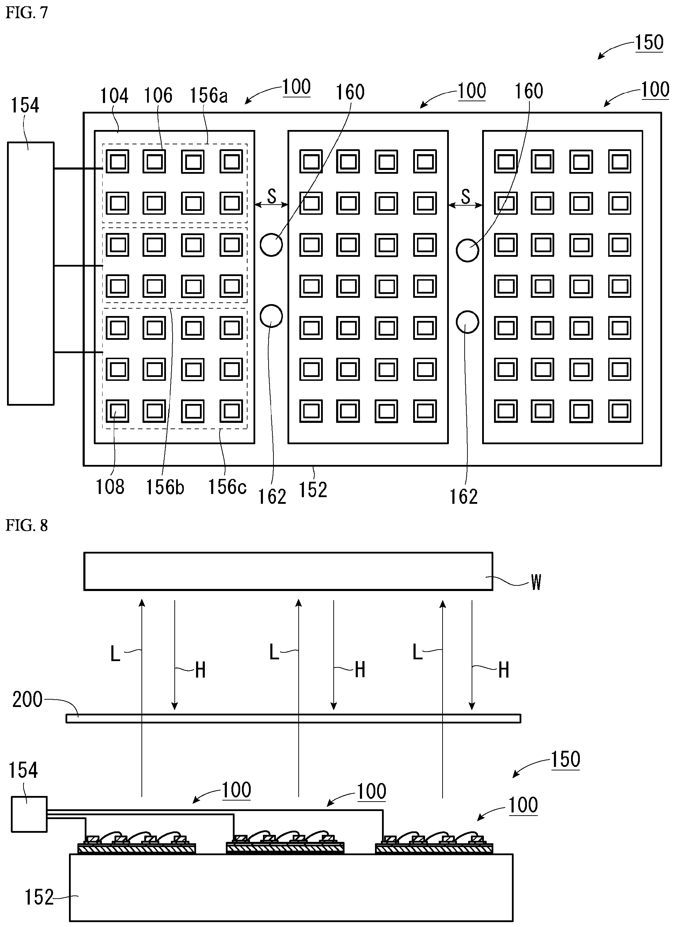

Besides, in the heating apparatus 150 described above, the plural lamps 100, when attached to the heat dissipation member 152, are disposed such that each lamp 100 produces the gap S at part or the entirety of the circumference thereof against at least one lamp 100 adjacent thereto. Alternatively, as shown in FIG. 7, at least either temperature sensors 160 or infrared cameras 162 (both the temperature sensors 160 and the infrared cameras 162 in FIG. 7) may be disposed in the gaps S in order to measure the temperature of a wafer under heating.

For example, photovoltaic elements (photodiodes, etc.) can be used as the temperature sensors 160. In this case, the wavelength (of infrared rays) to be measured for temperature detection is set to be longer than that of rays of light emitted from the VCSEL elements 108. Specifically, the photovoltaic elements used for temperature detection are set to have a sensitivity for a wavelength of greater than or equal to 1.0pm and less than or equal to 3.0µm. Besides, photovoltaic elements, set to have a sensitivity for a wavelength of greater than or equal to 3.0µm and less than or equal to 8.0µm, may be additionally used for measuring low temperature.

The configuration makes it possible to heat the wafer by the heating apparatus 150, and simultaneously, obtain the temperature of the wafer; hence, it is made easy to appropriately manage the temperature of the wafer under heating.

It should be noted that the electric driver 154 may be set to regulate values of electric current to be supplied to the lamps 100 based on the temperature of the wafer detected by at least either the temperature sensors or the infrared cameras. With the setting, the temperature of the wafer under heating can be more appropriately managed.

The setting "the electric driver 154 regulates the values of electric current to be supplied to the lamps 100" can be exemplified by directly inputting a signal, outputted from an illuminance sensor for measuring the illuminance of rays of light emitted from the lamps 100, to the electric driver 154 as a dimming signal through an inverting amplifier circuit and then regulating the values of electric current based on the outputted signal (dimming signal). With the exemplary setting, regulating the values of electric current can be processed at a higher speed than a conventional process of regulating the values of electric current after a microcomputer or sequencer receives the signal from the illuminance sensor.

### (Modification 3)

Moreover, in the exemplary embodiment described above, the plural lamps 100 are disposed on the single heat dissipation member 152. Alternatively, a single or plurality of heat dissipation members 152 may be prepared to be equal in number to a single or plurality of lamps 100; then, the single or plurality of lamps 100 may be attached to the single or plurality of heat dissipation members 152 on a one-to-one basis. In the configuration, the amount of heat dissipated from each heat dissipation member 152 can be regulated by regulating the amount of water (in the case of water cooling) or the amount of air (in the case of air cooling) to be supplied to each heat dissipation member 152, whereby the temperature of the VCSEL elements 108 can be regulated in each lamp 100 corresponding to each heat dissipation member 152.

### (Modification 4)

Furthermore, depending on time-dependent deterioration of the VCSEL elements 108, the electric driver 154 may be controlled to increase the values of electric current to be supplied to the deteriorated VCSEL elements 108. The output power of light from the VCSEL elements 108 degrades with the time-dependent deterioration of the VCSEL elements 108. In order to cope with this, the values of electric current to be supplied to the deteriorated VCSEL elements 108 are increased, whereby the output power of light emitted from the deteriorated VCSEL elements 108 can be kept constant; thus, it is made possible to perform constant illuminance operation.

It should be noted that the electric driver 154 may be controlled to uniquely regulate the values of electric current to be supplied to the lamps 100 on a lamp basis depending on the time-dependent deterioration of the VCSEL elements 108 in each lamp 100.

### (Modification 5)

Yet furthermore, as shown in FIG. 8, an optical filter 200 may be arranged and set between the lamps 100 and a wafer W. The optical filter 200 serves to block rays of light having a wavelength longer than that of rays of light to be detected by the temperature sensors or infrared cameras described above.

With the configuration, radiant heat H (infrared rays of light), emitted from the wafer W heated by the rays of light L emitted from the lamps 100, can be cut by the optical filter 200 so as not to reach the lamps 100; hence, the lamps 100, especially the VCSEL elements 108, can be avoided from undesirably becoming high in temperature.

### (Modification 6)

The configurations for using the VCSEL elements 108 as the light source elements have been explained so far; however, LED elements may be used as the light source elements instead of the VCSEL elements 108.

It should be noted that, where the amount of light is constant in irradiation of light energy on a silicon wafer (wafer), the silicon wafer absorbs rays of light emitted from the VCSEL elements 108 (rays of light [with a long wavelength] closer to infrared light) at a higher absorption rate than rays of light emitted from LED elements (rays of light with a wavelength in a visible light range); hence, the VCSEL elements 108 are advantageous for increase in temperature of the silicon wafer. Because of this, it is preferable to use the VCSEL elements 108 as the light source elements.

It should be understood that the embodiment herein disclosed is illustrative only and is not restrictive in all aspects. It is intended that the scope of the present invention is indicated by the appended claims rather than the explanation described above and encompasses all the changes that come within the meaning and the range of equivalents of the appended claims.

### REFERENCE SIGNS LIST

- 100: Lamp for heating,
- 102: Heat dissipation substrate
- 104: Insulating layer
- 106: Wiring pattern
- 108: VCSEL element
- 109: Joining material
- 110: Metal wiring
- 150: Heating apparatus
- 152: Heat dissipation member
- 154: Electric driver
- 155: Thermally conductive material
- 156: Group (of VCSEL elements 108)
- 160: Temperature sensor
- 162: Infrared camera
- 200: Optical filter
- 210: Insulating material

- L: Light
- S: Gap (between adjacent lamps 100)
- W: Wafer
- K: Missing part
- H: Radiant heat

## Claims

1. A lamp for heating comprising:
a heat dissipation substrate made of metal;
an insulating layer disposed on the heat dissipation substrate;
a plurality of wiring patterns disposed on the insulating layer;
a plurality of light source elements disposed on the plurality of wiring patterns on a one-to-one basis;
a joining material electrically joining each of the plurality of wiring patterns and each of the plurality of light source elements; and
a metal wiring electrically connecting each adjacent pair of the plurality of light source elements.

2. A lamp for heating comprising:
an insulating material made of ceramic;
a plurality of wiring patterns disposed on the insulating material;
a plurality of light source elements disposed on the plurality of wiring patterns on a one-to-one basis;
a joining material electrically joining each of the plurality of wiring patterns and each of the plurality of light source elements; and
a metal wiring electrically connecting each adjacent pair of the plurality of light source elements.

3. The lamp according to claim 1 or 2, wherein a VCSEL (Vertical Cavity Surface Emitting Laser) element is used as the each of the plurality of light source elements.

4. A heating apparatus comprising:
a plurality of lamps, each of the plurality of lamps being identical to the lamp recited in any of claims 1 to 3;
a heat dissipation member to which the each of the plurality of lamps is attached through a thermally conductive material; and
an electric driver driving the plurality of light source elements.

5. The heating apparatus according to claim 4, wherein
the plurality of light source elements disposed in the each of the plurality of lamps are divided into a plurality of groups, and
the electric driver separately drives the plurality of light source elements on a group basis.

6. The heating apparatus according to claim 5, wherein the electric driver controls the plurality of light source elements on the group basis with shifted timing.

7. The heating apparatus according to any one of claims 4 to 6, wherein the plurality of lamps are attached to the heat dissipation member such that the each of the plurality of lamps produces a gap at part or entirety of a circumference thereof against one adjacent thereto of the plurality of lamps.

8. The heating apparatus according to claim 7, wherein at least either a temperature sensor or an infrared camera is disposed in the gap so as to measure a temperature of a wafer under heating.

9. The heating apparatus according to claim 8, wherein the electric driver regulates values of electric current to be supplied to the plurality of lamps based on the temperature of the wafer detected by the at least either the temperature sensor or the infrared camera.

10. The heating apparatus according to any one of claims 4 to 6, wherein the electric driver increases values of electric current to be supplied to the plurality of light source elements depending on time-dependent deterioration of the plurality of light source elements.

11. The heating apparatus according to any one of claims 4 to 6, wherein the electric driver uniquely regulates values of electric current to be supplied to the plurality of lamps on a lamp basis depending on time-dependent deterioration of the plurality of light source elements in the each of the plurality of lamps.

12. The heating apparatus according to claim 8 or 9, further comprising:
an optical filter arranged and set between the plurality of lamps and the wafer, wherein
the optical filter blocks rays of light having a wavelength longer than a wavelength detected by the at least either the temperature sensor or the infrared camera.
